# EUROPÄISCHE PATENTSCHRIFT

(11) **EP 1 089 945 B1**
(45) Veröffentlichungstag und Bekanntmachung des Hinweises auf die Patenterteilung: **10.07.2002**
(21) Anmeldenummer: 99927856.7
(22) Anmeldetag: 02.06.1999
(51) Int. Cl.: C03C 17/245, C03C 17/34, C23C 14/08, C23C 14/00

(54) **THERMOCHROME BESCHICHTUNG**
THERMOCHROMIC COATING
REVETEMENT THERMOCHROMIQUE

(30) Priorität: 03.06.1998 DE 19824800; 09.12.1998 DE 19856821; 23.12.1998 DE 19860026
(43) Veröffentlichungstag der Anmeldung: 11.04.2001
(73) Patentinhaber: Meyer, Bruno K., 35581 Wetzlar-Münchholzhausen (DE)
(72) Erfinder: MEYER, Bruno, K., D-35581 Wetzlar-Münchholzhausen (DE); SCHALCH, Dirk, D-35392 Gie en (DE); CHRISTMANN, Thomas, D-66265 Heusweiler (DE)
(74) Vertreter: Herzog, Markus, Dipl.-Phys. Dr.
(86) Internationale Anmeldenummer: EP9903843
(87) Internationale Veröffentlichungsnummer: WO9962836

(56) Entgegenhaltungen:
- US-A- 4 401 690
- DATABASE INSPEC [Online] INSTITUTE OF ELECTRICAL ENGINEERS, STEVENAGE, GB PING JIN ET AL: "Thermochromic films of V/sub 1-x/M/sub x/O/sub 2/ for optical switchable glazing deposited by reactive magnetron sputtering" Database accession no. 5114911 XP002116232 & REPORTS OF THE NATIONAL INDUSTRIAL RESEARCH INSTITUTE OF NAGOYA, JULY-AUG. 1995, JAPAN, Bd. 44, Nr. 7-8, Seiten 367-381, ISSN: 1340-3729
- DATABASE INSPEC [Online] INSTITUTE OF ELECTRICAL ENGINEERS, STEVENAGE, GB TAZAWA M ET AL: "Optical constants of V/sub 1-x/W/sub x/O/sub 2/ thermochromic films and their application to the selective radiating material" Database accession no. 5227480 XP002116233 & OPTICAL MATERIALS TECHNOLOGY FOR ENERGY EFFICIENCY AND SOLAR ENERGY CONVERSION XIV, SAN DIEGO, CA, USA, 12-13 JULY 1995, Bd. 2531, Seiten 326-332, Proceedings of the SPIE - The International Society for Optical Engineering, 1995, SPIE-Int. Soc. Opt. Eng, USA ISSN: 0277-786X
- KHAN K A ET AL: "Thermochromic sputter-deposited vanadium oxyfluoride coatings with low luminous absorptance" APPLIED PHYSICS LETTERS, Bd. 55, Nr. 1, 3. Juli 1989 (1989-07-03), Seiten 4-6 6, XP002108904 ISSN: 0003-6951
- CHEMICAL ABSTRACTS, vol. 126, no. 11, 17. März 1997 (1997-03-17) Columbus, Ohio, US; abstract no. 146250, TAZAWA, MASATO ET AL: "New selective radiating materials combined with VO2 type thermochromic films" XP002116252 & TAIYO ENERUGI (1996), 22(6), 51-57 ,
- CHEMICAL ABSTRACTS, vol. 124, no. 10, 4. März 1996 (1996-03-04) Columbus, Ohio, US; abstract no. 131358, LEE, SI-WOO ET AL: "A study on the thermochromism of V1-xMxO2 thin film" XP002116253 & HAN'GUK CHAELYO HAKHOECHI (1994), 4(6), 715-22 ,
- CHEMICAL ABSTRACTS, vol. 123, no. 24, 11. Dezember 1995 (1995-12-11) Columbus, Ohio, US; abstract no. 318728, TAZAWA, MASATO ET AL: "Optical constants of V1-xWxO2 thermochromic films and their application to the selective radiating material" XP002116254 & PROC. SPIE-INT. SOC. OPT. ENG. (1995), 2531(OPTICAL MATERIALS TECHNOLOGY FOR ENERGY EFFICIENCY AND SOLAR ENERGY CONVERSION XIV), 326-32 ,
- CHEMICAL ABSTRACTS, vol. 123, no. 16, 16. Oktober 1995 (1995-10-16) Columbus, Ohio, US; abstract no. 212468, JIN, PING ET AL: "Thermochromic films of V1-xMxO2 for optical switchable glazing deposited by reactive magnetron sputtering" XP002116255 & NAGOYA KOGYO GIJUTSU KENKYUSHO HOKOKU (1995), 44(7/8), 367-81 ,
- CHEMICAL ABSTRACTS, vol. 123, no. 16, 16. Oktober 1995 (1995-10-16) Columbus, Ohio, US; abstract no. 206325, JIN, P. ET AL: "Preparation of metal-doped thermochromic VO2 films for smart window coatings" XP002116256 & TRANS. MATER. RES. SOC. JPN. (1994), 18A(ECOMATERIALS), 533-6 ,
- CHEMICAL ABSTRACTS, vol. 122, no. 10, 6. März 1995 (1995-03-06) Columbus, Ohio, US; abstract no. 117634, SOBHAN, M.A. ET AL: "Reactively sputtered thermochromic tungsten doped VO2 films" XP002116257 & PROC. SPIE-INT. SOC. OPT. ENG. (1994), 2255(OPTICAL MATERIALS TECHNOLOGY FOR ENERGY EFFICIENCY AND SOLAR ENERGY CONVERSION XIII), 423-34 ,
- CHEMICAL ABSTRACTS, vol. 121, no. 4, 25. Juli 1994 (1994-07-25) Columbus, Ohio, US; abstract no. 41115, JIN, PING ET AL: "Sputter deposition of thermochromic VO2 films for smart window for building energy management" XP002116258 & FRONT. SCI. SER. (1993), 7(NEW ENERGY SYSTEMS AND CONVERSIONS), 301-4 ,
- CHEMICAL ABSTRACTS, vol. 104, no. 16, 21. April 1986 (1986-04-21) Columbus, Ohio, US; abstract no. 132866, JORGENSON, G. V. ET AL: "Thermochromic materials research for optical switching films" XP002116259 & PROC. SPIE-INT. SOC. OPT. ENG. (1985), 562(OPT. MATER. TECHNOL. ENERGY EFFIC. SOL. ENERGY CONVERS. 4), 2-5 ,
- CHEMICAL ABSTRACTS, vol. 106, no. 22, 1. Juni 1987 (1987-06-01) Columbus, Ohio, US; abstract no. 181283, LEE, J. C. ET AL: "Thermochromic materials research for optical switching" XP002116260 & PROC. SPIE-INT. SOC. OPT. ENG. (1987), 692(MATER, OPT. SOL. ENERGY CONVERS. ADV. LIGHT. TECHNOL.), 2-7 ,

## Beschreibung

Die vorliegende Erfindung betrifft eine thermochrome Beschichtung bzw. ein Verfahren zur Herstellung derselben. Derartige Beschichtungen sollen im Gebäudebau bei Glasfenstern oder Glasfassaden eingesetzt werden, um durch Ausnutzung des sich mit der Temperatur ändernden Transmissionsgrads dieser Beschichtungen das Raumklima im Gebäudeinneren beeinflussen zu können.

Ein Beschichtungsmaterial, welches sich für die Beschichtung von Architekturglas als vorteilhaft erwiesen hat, ist Vanadiumoxid. Es ist bekannt, daß kristallines Vanadiumoxid eine Schalttemperatur T_{S} im Bereich von 68°C aufweist. D.h. bei dieser Temperatur findet ein Halbleiter-Metall-Phasenübergang statt, so daß bei Temperaturen oberhalb dieser Schalttemperatur T_{S} der Transmissionsgrad insbesondere im Infrarot-Bereich, d.h. im Wellenlängenbereich von 1000 nm und mehr, aufgrund des dann vorliegenden metallischen Zustands deutlich geringer ist, als bei einer Temperatur unterhalb der Schalttemperatur T_{S}, bei welcher das Vanadiumoxid, d.h. Vanandiumdioxid, im Halbleiterzustand ist.

Es wurden in der Vergangenheit verschiedene Versuche unternommen, diese im Bereich von 68°C liegende Schalttemperatur in den Bereich der Raumtemperatur zu verschieben. Es hat sich gezeigt, daß eine Dotierung des Vanadiumoxids mit Wolfram zu einer Verschiebung der Schalttemperatur in den Bereich der Raumtempertur führt, wobei der Wolframanteil hier im Bereich 2,6 % liegen sollte. Es hat sich jedoch ferner gezeigt, daß der Wolframeinbau zu einer geringfügigen Absenkung des Transmissionsgrads im sichtbaren führen kann.

Ferner ist es bekannt, Vanadiumdioxidschichten mit Fluor zu dotieren, wobei bei Fluordotierung das Problem besteht, daß bei Abscheidung dieser Schichten durch reaktives Hochfrequenz- oder Radiofrequenz-Zerstäuben ein Fluoreinbau in das Vanadiumoxidgitter lediglich bei Abscheidetemperaturen unter 600°C erhalten wird. Derartig niedrige Abscheidetemperaturen haben jedoch eine Auswirkung auf die Kristallstruktur des Vanadiumoxidgitters, so daß mit sinkender Abscheidetemperatur ein Übergang vom polykristallinen zum amorphen Zustand auftreten kann. Die Folge dieser zunehmenden Unordnung im Gitter ist eine verschlechterte Schalteigenschaft der so erhaltenen Schichten.

Es ist eine Aufgabe der vorliegenden Erfindung, eine thermochrome Beschichtung, insbesondere für Glas, vorzusehen, welche bei guten Schalteigenschaften eine im Bereich der Raumtemperatur liegende Schalttemperatur und ein hinsichtlich bekannter Schichten verbessertes Transmissionsverhalten im sichtbaren Spektralbereich aufweist. Ferner ist es eine Aufgabe der vorliegenden Erfindung, ein Verfahren zur Herstellung derartiger Schichten vorzusehen.

Der erstgenannte Aspekt der Aufgabe wird gemäß der vorliegenden Erfindung durch eine thermochrome Beschichtung, insbesondere für Glas, gelöst, welche eine Vanadiumoxidschicht umfaßt, die ferner Wolfram und Fluor enthält.

Es hat sich gezeigt, daß bei Kodotierung des Vanadiumoxidgitters mit Wolfram und Fluor ein synergetischer Effekt auftritt, der aus den beiden vorangehend geschilderten Einzelverhalten von wolframdotierten Beschichtungen einerseits und fluordotierten Beschichtungen andererseits nicht zu erwarten war. Die Kodotierung des Vanadiumoxids mit Wolfram und Fluor hat zum einen die Folge, daß aufgrund des Wolframeinbaus die Absenkung der Schalttemperatur T_{S} in den Bereich der Raumtemperatur auftritt. Ferner hat der gleichzeitige Einbau von Fluor zur Folge, daß der Transmissionsgrad der so hergestellten Beschichtungen im sichtbaren und ultravioletten Spektralbereich, d.h. insbesondere im Wellenlängenbereich von 500 nm und weniger, verbessert wird. Die Folge daraus ist, daß das äußere Erscheinungsbild aufgrund der durch die Anhebung des Transmissionsgrads im angesprochenen Wellenlängenbereich verbesserten Farbneutralität gegenüber bekannten thermochromen Beschichtungen, beispielsweise lediglich mit Wolfram dotierten Vanadiumoxidschichten, deutlich verbessert werden kann. Diese bekannten Beschichtungen weisen im allgemeinen einen gelb/grün-schillernden Farbeffekt auf.

Der Wolframgehalt kann bei den thermochromen Beschichtungen gemäßder vorliegenden Erfindung im Bereich von 0,01 bis 3 Atom-%, vorzugsweise 1,0 bis 2,6 Atom-% liegen.

In entsprechender Weise kann der Fluorgehalt im Bereich von 0,01 bis 2 Atom-%, vorzugsweise 0,5 bis 1,5 Atom-% liegen.

Um bei der Abscheidung der erfindungsgemäßen Schichten das vorangehend angesprochene Problem der zunehmenden Unordnung im Gitter bei Senken der Raumtemperatur, was zum Fluoreinbau erforderlich ist, vermeiden zu können, wird ferner vorgeschlagen, daß eine Zwischenschicht zwischen der Vanadiumoxidschicht und einem diese Vanadiumoxidschicht tragenden Substrat vorgesehen ist, wobei die Zwischenschicht eine Titanoxidschicht umfaßt. Es hat sich gezeigt, daß dann, wenn die mit Fluor und Wolfram zu dotierende Vanadiumoxidschicht auf dieser Titanoxidschicht abgeschieden wird, die im Vanadiumoxidgitter vorhandenen Verspannungen reduziert werden können und die Wachstumsbedingungen für die Vanadiumoxidschicht bei niedrigen Abscheidetemperaturen, beispielsweise im Bereich von 300°C, verbessert werden können, so daß die Absenkung der Abscheidetemperaturen auf den angegebenen Bereich nicht zu einer dementsprechenden Verschlechterung der optischen Eigenschaften führt.

Die Erfindung betrifft ferner eine thermochrome Beschichtung, insbesondere für Glas, umfassend eine Vanadiumoxidschicht, welche Wolfram, vorzugsweise in einem Bereich von 1,0 bis 2,6 Atom-%, am meisten bevorzugt im Bereich von 1,6 bis 2 Atom-% enthält, und wobei die Beschichtung ferner eine zwischen der Vanadiumoxidschicht und einem die Vanadiumoxidschicht tragenden Substrat angeordnete oder anordenbare Zwischenschicht aus Titanoxid umfaßt. Es hat sich gezeigt, daß auch bei Verwendung von lediglich mit Wolfram dotiertem Vanadiumoxid das Vorsehen der Titanoxidzwischenschicht vorteilhaft sein kann, insbesondere wenn beispielsweise zur Beeinflussung des Wolframgehalts in der thermochromen Schicht die Abscheidetemperatur gesenkt wird. Aufgrund der Titanoxidschicht werden, ebenso wie vorangehend angesprochen, die Abscheidebedingungen für die wolframdotierte Vanadiumoxidschicht verbessert, so daß in entsprechender Weise die optischen Eigenschaften derartiger thermochromer Beschichtungen verbessert werden.

Ferner betrifft die Erfindung eine thermochrome Beschichtung, insbesondere für Glas, umfassend eine Vanadiumoxidschicht, welche Fluor, vorzugsweise in einem Bereich von 0,01 bis 3 Atom-%, am meisten bevorzugt im Bereich von 0,5 bis 2,5 Atom-%, enthält, und wobei die Beschichtung ferner eine zwischen der Vanadiumoxidschicht und einem die Vanadiumoxidschicht tragenden Substrat angeordnete oder anordenbare Zwischenschicht aus Titanoxid umfaßt. Der vorangehend beschriebene vorteilhafte Effekt einer Titanoxidzwischenschicht kann auch bei einer lediglich mit Fluor dotierten Vanadiumoxidschicht zu erheblichen Verbesserungen der optischen Eigenschaften führen.

Um die Nachoxidation der Vanadiumoxidschicht - mit Wolfram oder Wolfram und Fluor dotiert - zu verhindern, wird vorgeschlagen, daß auf der Vanadiumoxidschicht ferner eine Siliziumoxinitrid-Abdeckungsschicht vorgesehen ist. Diese Siliziumoxinitrid-Schicht hat nicht nur das Verhindern der Nachoxidation zur Folge, sondern bildet insbesondere eine Anti-Reflexionsschicht, durch welche zusätzlich die Transmission insbesondere im sichtbaren Spektralbereich verbessert werden kann.

Dabei hat es sich als vorteilhaft erwiesen, wenn die Abdeckungsschicht eine Dicke im Bereich von 10 bis 300 nm, vorzugsweise 10 bis 100 nm aufweist.

Die Vanadiumoxidschicht kann eine Dicke im Bereich von 30 bis 350 nm, vorzugsweise 50 bis 150 nm aufweisen.

Die angesprochene Zwischenschicht kann beispielsweise eine Dicke im Bereich von 10 bis 100 nm, vorzugsweise 30 bis 70 nm aufweisen.

Der zweitgenannte Aspekt der vorangehend angegebenen Aufgabe wird gemäß der vorliegenden Erfindung durch ein Verfahren zur Herstellung einer thermochromen Beschichtung, insbesondere für Glas, gelöst, welches a) das Abscheiden einer mit Wolfram und Fluor dotierten Vanadiumoxidschicht umfaßt.

Das Abscheiden der Vanadiumoxidschicht kann durch ein Zerstäubungsverfahren, vorzugsweise Hochfrequenz-Zerstäuben oder Magnetron-Zerstäuben, durchgeführt werden.

Diese mit Wolfram und Fluor dotierte Vanadiumoxidschicht kann beispielsweise durch reaktive Hochfrequenz- bzw. Radiofrequenz-Zerstäubung eines Wolfram enthaltenden Vanadium-Targets in einer ein Sauerstoff/Argon-Gemisch und Trifluormethan (CHF₃) enthaltenden Atmosphäre abgeschieden werden.

Dabei ist vorzugsweise der Trifluormethan-Partialdruck im Bereich von 0,5 - 5 · 10⁻³ Pa.

Ferner liegt die Abscheideleistung vorzugsweise im Bereich von 200 - 600 W und die Abscheidetemperatur liegt vorzugsweise im Bereich von 200 - 600°C, am meisten bevorzugt bei ca. 300°C. Dies ist ein Temperaturbereich, bei weichem auch der Einbau von Fluor in das Vanadiumoxidgitter erreicht wird.

Um zu verhindern, daß bei der Abscheidung ein amorphes Vanadiumoxidphasengemisch erzeugt wird, das im Bereich von unter 100°C keinen Metall-Halbleiter-Phasenübergang zeigt, wird vorzugsweise vor dem Schritt a) eine Titanoxidschicht auf dem Substrat abgeschieden. Wie bereits erwähnt, hat diese Titanoxidschicht zur Folge, daß die im Vanadiumoxidgitter erzeugten Verspannungen vermindert werden und für die Vanadiumoxidschicht insbesondere bei Abscheidetemperaturen im Bereich von 300°C verbesserte Wachstumsbedingungen geschaffen werden.

Auch die Titanoxidschicht kann durch ein Zerstäubungsverfahren, vorzugsweise Magnetron-Zerstäuben oder reaktives Hochfrequenz- bzw. Radiofrequenz-Zerstäuben eines Titan-Targets in einer ein Sauerstoff/Argon-Gemisch enthaltenden Atmosphäre abgeschieden werden.

Dabei liegt bei Durchführung eines reaktiven Hochfrequenz-Zerstäubens die Abscheideleistung bei Abscheidung der Titanoxidschicht vorzugsweise im Bereich von 200 bis 600 W und eine Abscheidetemperatur liegt bei Abscheidung der Titanoxidschicht vorzugsweise im Bereich von Raumtemperatur bis zu 600°C.

Um eine Nachoxidation der abgeschiedenen Vanadiumoxidschicht und eine dadurch induzierte Verschlechterung der optischen Eigenschaften zu vermeiden, wird vorgeschlagen, daß nach dem Schritt a) eine Siliziumoxinitrid-Schicht auf der Vanadiumoxidschicht abgeschieden wird. Wie bereits angesprochen, hat diese Siliziumoxinitrid-Schicht ferner den vorteilhaften Effekt zur Folge, daß sie als Anti-Reflexionsschicht wirkt und dadurch die Transmissivität der erfindungsgemäßen Beschichtung insbesondere im sichtbaren Spektralbereich deutlich verbessert wird.

Die Siliziumoxinitrid-Schicht kann beispielsweise durch ein Zerstäubungsverfahren, vorzugsweise Magnetron-Zerstäuben oder reaktives Hochfrequenz-bzw. Radiofrequenz-Zerstäuben eines Silizium-Targets in einer ein Argon/Sauerstoff/Stickstoff-Gemisch enthaltenden Atmosphäre abgeschieden werden.

Dabei liegt bei Durchführung eines reaktiven Hochfrequenz-Zerstäubens die Abscheideleistung vorzugsweise im Bereich von 200 bis 300 W und die Abscheidetemperatur bei Abscheidung der Siliziumoxinitrid-Schicht liegt vorzugsweise im Bereich von Raumtemperatur bis 200°C.

Die vorliegende Erfindung betrifft ferner ein Verfahren zur Herstellung einer thermochromen Beschichtung, insbesondere für Glas, umfassend:
a) das Abscheiden einer Titanoxidschicht auf einem Substrat, vorzugsweise Glassubstrat, und
b) das Abscheiden einer vorzugsweise mit Wolfram oder Fluor dotierten Vanadiumoxidschicht auf der Titanoxidschicht.

Die Erfindung wird nachfolgend mit Bezug auf die beiliegenden Zeichnungen anhand bevorzugter Ausführungsformen detailliert beschrieben. Es zeigt:
- Fig. 1: den prinzipiellen Aufbau einer erfindungsgemäßen thermochromen Beschichtung für ein Fensterglas;
- Fig. 2: die wellenlängenabhängige Transmission verschiedener thermochromer Beschichtungen auf Vanadiumoxidbasis;
- Fig. 3: ein der Fig. 1 entsprechendes Diagramm mit anderem Fluorgehalt.

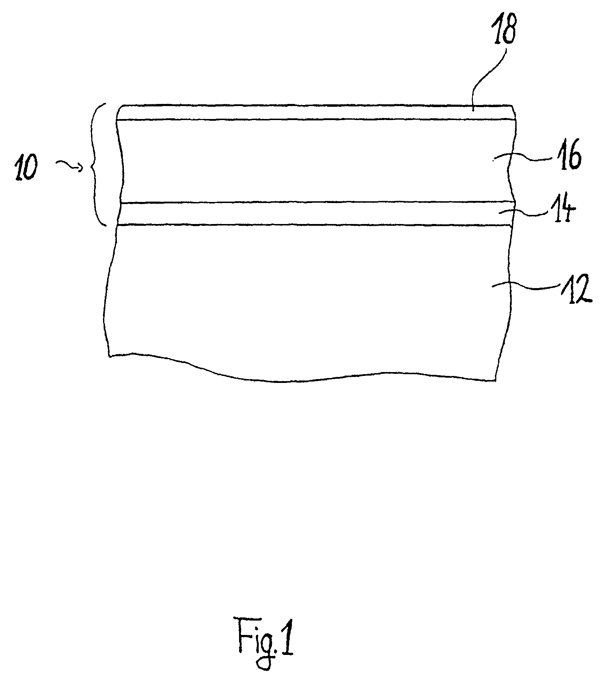

Fig. 1 zeigt den prinzipiellen Aufbau eines Beispiels einer erfindungsgemäßen Beschichtung 10, wie sie beispielsweise auf eine Fensterglasscheibe 12 aufgebracht werden kann. Die Beschichtung 10 umfaßt als erste, unmittelbar auf die Glasscheibe 12 aufgebrachte Schicht eine Titanoxidschicht 14, welche durch reaktives Hochfrequenz-Zerstäuben mit den folgenden Abscheidebedingungen hergestellt werden kann:

| | | |
|---|---|---|
| 1. | Zerstäubungs-Target | Titan |
| 2. | Prozeßgas | Sauerstoff/Argon-Gemisch mit einem Verhältnis beispielsweise im Bereich von 0,16, |
| 3. | Prozeßdruck | 10⁻¹ Pa, |
| 4. | Abscheideleistung | 300 W |
| 5. | Abscheidetemperatur | Raumtemperatur bis 600°C. |

Es wird auf diese Art und Weise eine TiO₂-Schicht gebildet, welche eine Zwischenschicht zwischen dem Glassubstrat 12 und der nachfolgend abzuscheidenden dotieren Vanadiumoxidschicht 16 ist. Da die Vanadiumoxidschicht 16 sowohl mit Wolfram als auch mit Fluor dotiert werden soll, muß die Abscheidetemperatur für diese auf weniger als 600°C gesenkt werden, so daß bei Weglassung der Titanoxid-Zwischenschicht ein amorphes Vanadiumoxidgemisch erzeugt werden würde, das nicht die gewünschten optischen Eigenschaften aufweist. Die TiO₂-Zwischenschicht sieht für die Vanadiumoxidschicht verbesserte Wachstumsbedingungen insbesondere bei den niederen Abscheidetemperaturen vor.

Die Abscheidebedingungen für die ebenfalls durch durch reaktives Hochfrequenz-Zerstäuben hergestellte Schicht 16, welche die eigentliche thermochrome Schicht bildet, sind wie folgt:

| | | |
|---|---|---|
| 1. | Zerstäubungs-Target | Vanadium mit beispielsweise stabartigen Wolframeinsätzen, |
| 2. | Prozeßgas | Sauerstoff/Argon-Gemisch (Verhältnis 0,16) + CHF₃ |
| 3. | Prozeßdruck | 10⁻¹ Pa, |
| 4. | CHF₃-Partialdruck | 0,5 - 5 · 10⁻³ Pa, |
| 5. | Abscheideleistung | 200 - 600 W, |
| 6. | Abscheidetemperatur | 200 - 600°C. |

Bei diesen Abscheidebedingungen kann der gezielte Einbau von Fluor und Wolfram in das Vanadiumoxidgitter erhalten werden, so daß letztendlich eine durch die Formel V_{1-X} W_{X} O_{2-Y} F_{Y} beschreibbare thermochrome Schicht erhalten wird.

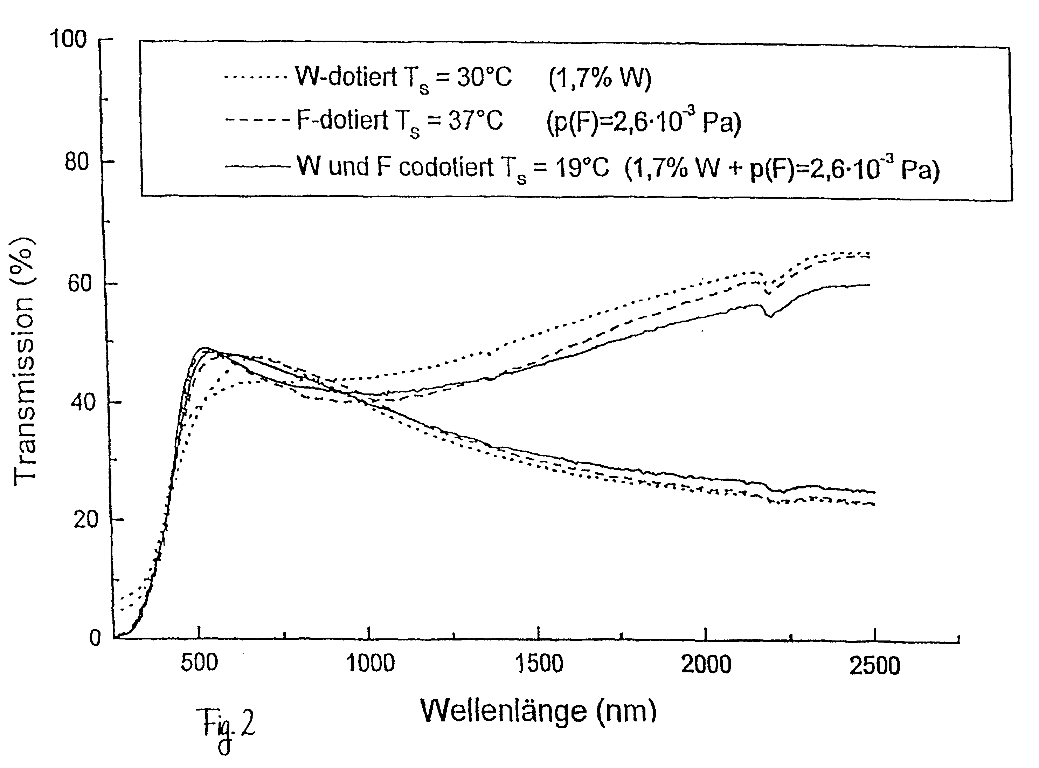

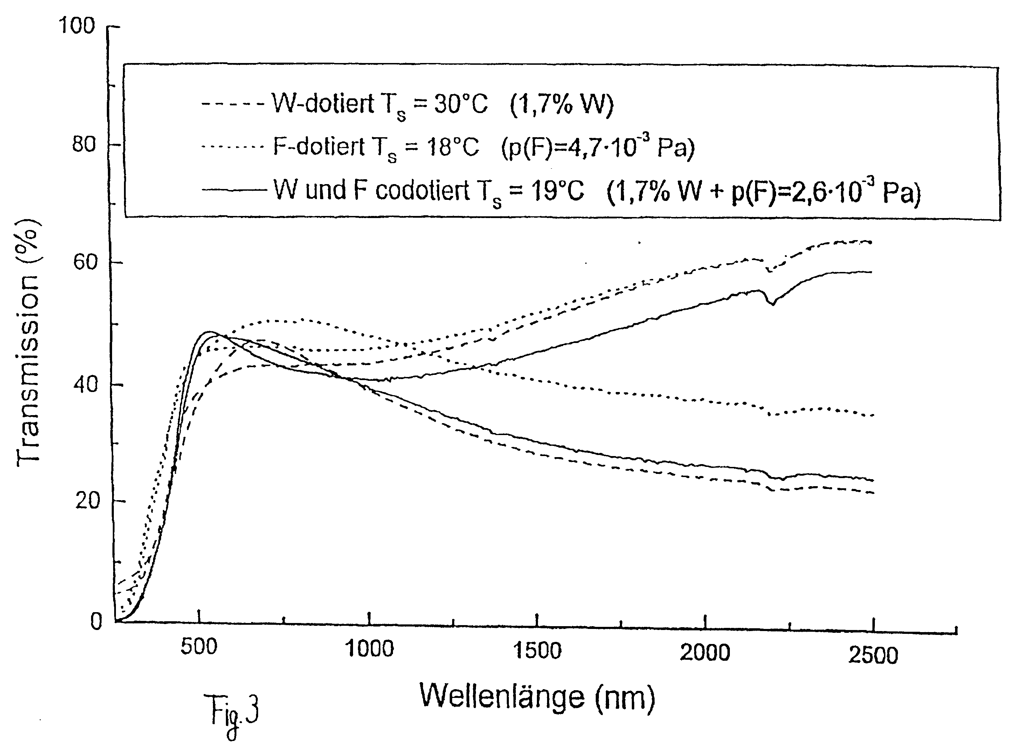

Wie nachfolgend mit Bezug auf die Figuren 2 und 3 beschrieben, führt der gemeinsame Einbau von Fluor und Wolfram einerseits zur Herabsetzung der Phasenübergangstemperatur, d.h. der Schalttemperatur T_{S}, und andererseits zur Verschiebung der Absorptionskante weiter in den blauen Spektralbereich.

Auf der eigentlichen thermochromen Schicht 16 ist ferner eine Siliziumoxinitrid-Abdeckungschicht 18 vorgesehen, welche ebenfalls durch reaktives Hochfrequenz-Zerstäuben mit den folgenden Abscheideparametern hergestellt wird:

| | | |
|---|---|---|
| 1. | Zerstäubungs-Target | Silizium; |
| 2. | Prozeßgas | Argon/Sauerstoff/Stickstoff-Gemisch |
| 3. | Prozeßdruck | 10⁻¹ Pa, |
| 4. | Abscheideleistung | 200 - 300 W, |
| 5. | Abscheidetemperatur | Raumtemperatur bis 200°C. |

Es wird somit eine durch die Formel SiO_{X} N_{Y} beschreibbare Abdeckungsschicht erzeugt, welche zum einen die Nachoxidation der thermochromen Vanadiumoxidschicht 16 verhindert und zum anderen als Anti-Reflexionsschicht dient, durch welche insbesondere im sichtbaren Spektralbereich die Transmission erhöht werden kann. Es haben sich hier beispielsweise Siliziumoxinitridschichten mit einem Brechungsindex n im Bereich von 1,65 als vorteilhaft erwiesen.

Bei der Abscheidung der Siliziumoxinitridschicht 18 sollten die Anteile der verschiedenen Prozeßgase Sauerstoff/Argon/Stickstoff (in Volumen-%) wie folgt eingestellt sein: 0/50/50 bis 50/50/0. Durch Variation der verschiedenen Werte läßt sich insbesondere die Anti-Reflexionseigenschaft, d.h. der Brechungsindex dieser Abdeckungsschicht 18 einstellen.

Die Fig. 2 zeigt das Transmissionsverhalten in Abhängigkeit der Wellenlängen für verschieden dotierte Vanadiumoxidschichten, wobei hier Schichten ohne zusätzliche Abdeckungschicht 18 verwendet wurden. Insbesondere ist der Vergleich zwischen einer lediglich mit Wolfram dotierten, einer lediglich mit Fluor dotierten und einer mit Fluor und Wolfram dotierten Schicht dargestellt. Die drei verschiedenen Schichten wurden mit den folgenden Abscheideparametern abgeschieden:

| Wolfram dotierte Schicht | | |
|---|---|---|
| 1. | Zerstäubungs-Target | Vanadium mit Wolframeinsätzen |
| 2. | Prozeßgas | Sauerstoff/Argon-Gemisch in einem Verhältnis von 0,15 |
| 3. | Prozeßdruck | 10⁻¹ Pa |
| 4. | Abscheideleistung | 300 W |
| 5. | Abscheidetemperatur | 500 °C. |

Es ergab sich dabei ein Wolframgehalt von 1,75 Atom-%.

| Fluor dotierte Schicht: | | |
|---|---|---|
| 1. | Zerstäubungs-Target | Vanadium |
| 2. | Prozeßgas | Argon/Sauerstoff-Gemisch mit einem Verhältnis von 0,11 und CHF₃ |
| 3. | Prozeßdruck | 10⁻¹ Pa |
| 4. | CHF₃-Paritaldruck | 2,6 · 10⁻³ Pa |
| 5. | Abscheideleistung | 300 W |
| 6. | Abscheidetemperatur | 300 °C. |

Es hat sich dabei ein Fluorgehalt von 0,7 Atom-% ergeben.

| W- und F-dotierte Schicht | | |
|---|---|---|
| 1. | Zerstäubungs-Target | Vandadium mit Wolframeinsätzen |
| 2. | Prozeßgas | Sauerstoff/Argon-Gemisch mit einem Verhältnis von 0,11 und CHF₃ |
| 3. | Prozeßdruck | 10⁻¹ Pa |
| 4. | CHF₃-Partialdruck | 2,6 · 10⁻³ Pa |
| 5. | Abscheideleistung | 300 W |
| 6. | Abscheidetemperatur | 300 °C. |

Es hat sich dabei ein Wolframgehalt von 1,75 Atom-% und ein Fluorgehalt von 0,7 Atom-% eingestellt.

Aus dem Vergleich der drei Kurven erkennt man, daß die mit Wolfram und Fluor dotierte Vanadiumoxidschicht bei eine Schalttemperatur T_{S} im Bereich von 19°C hinsichtich der Transmission im Bereich kleiner Wellenlängen erhöhte Werte sowohl bezüglich der Wolfram dotierten als auch der Fluor dotierten Schicht aufweist. Insbesondere weist diese mit Wolfram und Fluor dotierte Schicht hinsichtlich der lediglich mit Fluor dotierten Schicht eine gesenkte Schaltwellenlänge auf, d.h. der Transmissionsunterschied bei Über- bzw. Unterschreiten der Schalttemperatur setzt bereits bei Wellenlängen im Bereich von 800 nm ein, im Vergleich zu ca. 1000 nm bei der mit Fluor dotierten Schicht.

Die Fig. 3 zeigt den Vergleich der in Fig. 2 dargestellten Kurven für die mit Wolfram dotierte Schicht und die mit Wolfram und Fluor dotierte Schicht mit einer anderen nur mit Fluor dotierten Schicht, die aufgrund eines größeren Fluorgehalts eine weiter gesenkte Schalttemperatur aufweist, die jedoch insbesondere im Bereich kleiner Wellenlängen, d.h. bei ca. 500 nm und weniger, einen hinsichtlich der in Fig. 2 gezeigten Kurve der nur mit Fluor dotierte Probe gesenkten Transmissionsgrad aufweist.

Die Abscheidebedingungen bei der graphisch in Fig. 3 wiedergegebenen nur mit Fluor dotierten Schicht waren wie folgt:

| | | |
|---|---|---|
| 1. | Zerstäubungs-Target | Vanadium |
| 2. | Prozeßgas | Sauerstoff/Argon-Gemisch mit einem Verhältnis von 0,09 und CHF₃ |
| 3. | Prozeßdruck | 10⁻¹ Pa |
| 4. | CHF₃-Partialdruck | 4,7 · 10⁻³ Pa |
| 5. | Zerstäubungsleistung | 300 W |
| 6. | Zerstäubungstemperatur | 300 °C. |

Es hat sich dabei ein Fluorgehalt von 1,2 Atom-% eingestellt.

Der Vergleich der Figuren 2 und 3 zeigt, daß der durch Kodotierung des Vanadiumoxids mit Wolfram und Fluor erhaltene synergetische Effekt nicht zu erwarten war, da der zunehmende Einbau von Fluor in das Vanadiumoxid eigentlich einen gegenteiligen Effekt, nämlich die Verminderung der Transmissivität in diesem Bereich erwarten ließe.

Es sei darauf verwiesen, daß der Wolframanteil der thermochromen Schicht 16 durch Veränderung des Volumenanteils von Wolfram im Zerstäubungs-Target steuerbar ist. Der Fluoranteil ist durch Einstellung des CHF₃-Partialdrucks im Prozeßgas steuerbar.

Das Anheben des Transmissionsgrads im sichtbaren Spektralbereich und im blauen Bereich hat zur Folge, daß das optische Erscheinungsbild der erfindungsgemäßen thermochromen Beschichtung (mit und ohne Anti-Reflexionsschicht) gegenüber den aus dem Stand der Technik bekannten lediglich mit Wolfram oder lediglich mit Fluor dotierten Schichten verbessert werden kann, wobei gleichwohl von der Absenkung der Schalttemperatur in den Bereich der Raumtemperatur durch den Wolframeinbau Nutzen gemacht werden kann. Zwar steigt, wie man den Figuren 2 und 3 entnehmen kann, der Wellenlängenbereich, ab dem bei Auftreten des Schaltverhaltens ein Transmissionsunterschied zwischen der metallischen Phase und der halbleitenden Phase auftritt, aufgrund des Fluoreinbaus gegenüber dem rein mit Wolfram dotierten Material an, doch liegt dieser Wellenlängenbereich immer noch deutlich unter 1000 nm.

Es sei darauf verwiesen, daß allein durch das Vorsehen einer Titanoxid-Zwischenlage zwischen dem Glassubstrat und der Vanadiumoxidschicht eine Verbesserung des Transmissionsverhaltens erreicht werden kann, insbesondere auch dann, wenn die Schichten nur mit Wolfram oder Fluor dotiert werden. Der Grund hierfür ist wiederum die angesprochene Verbesserung der Wachstumsbedingungen für die Vanadiumoxidschicht und die somit erhaltene Verbesserung der Kristallstruktur. Das bedeutet, daß alleine das Anordnen einer Titanoxidzwischenlage unter der Vanadiumoxidschicht zu derart verbesserten Wachstumsbedingungen und somit verbesserten kristallographischen Strukturen in der Vanadiumoxidschicht führt, daß deren optische Eigenschaften unabhängig davon, ob keine Dotierung vorliegt oder ob mit Wolfram und/oder Fluor dotiert wird, deutlich verbessert werden können. Es sei darauf hingewiesen, daß eine Dotierung des Vanadiumoxids ausschließlich mit Fluor beispielsweise dadurch erhalten werden kann, daß als Zerstäubungs-Target lediglich ein Vanadiumkern ohne Wolframeinsätzen eingesetzt wird. Eine undotierte Vanadiumoxidschicht kann dann weiterhin dadurch erhalten werden, daß zusätzlich auch noch der Fluoreinbau durch Weglassen des Fluor enthaltenden Prozeßgases vermieden wird. Die Abscheidebedingungen für derartige Schichten, d.h. die Temperatur und die Leistungen, können dann so wie in den vorangehenden Beispielen angegeben gewählt werden.

Ferner sei darauf hingewiesen, daß, obgleich vorangehend die Herstellung der erfindungsgemäßen Beschichtung mit einem Hochfrequenz-Zerstäubungsverfahren beschrieben worden ist, auch andere Zerstäubungsverfahren, wie z.B. das Magnetron-Zerstäuben, eingesetzt werden können. Auch hier kann für die jeweiligen Abscheidebedingungen jeweils auf Parameterwerte oder Wertebereiche zurückgegriffen werden, wie sie beispielsweise vorangehend angegeben worden sind. Vorteil einer Herstellung der Beschichtung durch Magnetron-Zerstäubung ist jedoch, daß hinsichtlich der Hochfrequenz-Zerstäubung die Abscheideleistung gesenkt werden kann, was insbesondere beim großindustriellen Einsatz den erheblichen Vorteil gesenkter Herstellungskosten mit sich bringt.

Es sei noch darauf hingewiesen, daß mit dem Ausdruck Vanadiumoxid, wie er im vorliegenden Text verwendet wird, im allgemeinen ein Vanadiumdioxidgitter (VO₂) gemeint ist, in welchem beispielsweise bei Dotierung mit Fluor an manchen Stellen Sauerstoff durch Fluor ersetzt wird. In entsprechender Weise wird an manchen Stellen bei Wolframdotierung Vanadium durch Wolfram ersetzt. Es bleibt jedoch die im allgemeinen polykristalline Gitterstruktur des Vanadiumdioxids erhalten.

## Patentansprüche

1. Thermochrome Beschichtung, insbesondere für Glas, umfassend eine Vanadiumoxidschicht (16), welche ferner Wolfram und Fluor enthält.

2. Beschichtung nach Anspruch 1,
**dadurch gekennzeichnet, daß** der Wolframgehalt im Bereich von 0,01 bis 3,0 Atom-%, vorzugsweise 1,0 bis 2,6 Atom-% liegt.

3. Beschichtung nach einem der Ansprüche 1 oder 2,
**dadurch gekennzeichnet, daß** der Fluorgehalt im Bereich von 0,01 bis 2 Atom-%, vorzugsweise 0,5 bis 1,5 Atom-% liegt.

4. Beschichtung nach einem der Ansprüche 1 bis 3,
**gekennzeichnet durch** eine Zwischenschicht (14) zur Anordnung zwischen einem die Vanadiumoxidschicht (16) tragenden Substrat (12) und der Vanadiumoxidschicht (16), wobei die Zwischenschicht (14) eine Titanoxidschicht umfaßt.

5. Thermochrome Beschichtung, insbesondere für Glas, umfassend eine Vanadiumoxidschicht (16), welche Wolfram, vorzugsweise in einem Bereich von 1,0 bis 2,6 Atom-%, am meisten bevorzugt im Bereich von 1,6 bis 2,0 Atom-% enthält, und wobei die Beschichtung (10) ferner eine zwischen der Vanadiumoxidschicht (16) und einem die Vanadiumoxidschicht (16) tragenden Substrat (12) angeordnete oder anordenbare Zwischenschicht (14) aus Titanoxid umfaßt.

6. Thermochrome Beschichtung, insbesondere für Glas, umfassend eine Vanadiumoxidschicht (16), welche Fluor, vorzugsweise in einem Bereich von 0,01 bis 3 Atom-%, am meisten bevorzugt im Bereich von 0,5 bis 2,5 Atom-% enthält, und wobei die Beschichtung (10) ferner eine zwischen der Vanadiumoxidschicht (16) und einem die Vanadiumoxidschicht (16) tragenden Substrat (12) angeordnete oder anordenbare Zwischenschicht (14) aus Titanoxid umfaßt.

7. Beschichtung nach einem der Ansprüche 1 bis 6, ferner umfassend eine Siliziumoxinitrid-Abdeckungsschicht (18) auf der Vanadiumoxidschicht (16).

8. Beschichtung nach Anspruch 7,
**dadurch gekennzeichnet, daß** die Abdeckungsschicht (18) eine Dicke im Bereich von 10 bis 300 nm, vorzugsweise 10 bis 100 nm aufweist.

9. Beschichtung nach einem der Ansprüche 1 bis 8,
**dadurch gekennzeichnet**, daßdie Vanadiumoxidschicht eine Dicke im Bereich von 30 bis 350 nm, vorzugsweise 50 bis 150 nm aufweist.

10. Beschichtung nach einem der Ansprüche 4, 5 oder 6, oder einem der Ansprüche 7 bis 9, sofern auf Anspruch 4, 5 oder 6 rückbezogen,
**dadurch gekennzeichnet, daß** die Zwischenschicht (14) eine Dicke im Bereich von 10 bis 100 nm, vorzugsweise 30 bis 70 nm aufweist.

11. Verfahren zur Herstellung einer thermochromen Beschichtung (10), insbesondere für Glas, umfassend
a) das Abscheiden einer mit Wolfram und Fluor dotierten Vanadiumoxidschicht (16).

12. Verfahren nach Anspruch 11, **dadurch gekennzeichnet, daß** das Abscheiden der Vanadiumoxidschicht (16) durch ein Zerstäubungsverfahren, vorzugsweise Hochfrequenz-Zerstäuben oder Magnetron-Zerstäuben, durchgeführt wird.

13. Verfahren nach Anspruch 11 oder 12,
**dadurch gekennzeichnet**, daßdie dotierte Vanadiumoxidschicht durch reaktive Hochfrequenz-Zerstäubung eines Wolfram enthaltenden Vanadiumtargets in einer ein Sauerstoff/Argon-Gemisch und Trifluormethan enthaltenen Atmosphäre abgeschieden wird.

14. Verfahren nach Anspruch 13,
**dadurch gekennzeichnet, daß** ein Trifluormethan-Partialdruck im Bereich von 0,5 - 5 · 10⁻³ Pa liegt.

15. Verfahren nach einem der Ansprüche 13 oder 14,
**dadurch gekennzeichnet, daß** eine Abscheideleistung bei Abscheidung der Vanadiumoxidschicht im Bereich von 200 - 600 W liegt.

16. Verfahren nach einem der Ansprüche 13 bis 15,
**dadurch gekennzeichnet, daß** eine Abscheidetemperatur bei Abscheidung der Vanadiumoxidschicht im Bereich von 200 - 600°C, vorzugsweise bei ca. 300°C liegt.

17. Verfahren nach einem der Ansprüche 11 bis 16, ferner umfassend vor dem Schritt a) das Abscheiden einer Titanoxidschicht (14) auf dem Substrat (12).

18. Verfahren nach Anspruch 17,
**dadurch gekennzeichnet, daß** die Titanoxidschicht (14) durch ein Zerstäubungsverfahren, vorzugsweise Magnetron-Zerstäuben oder reaktives Hochfrequenz-Zerstäuben eines Titan-Targets in einer ein Sauerstoff/Argon-Gemisch enthaltenden Atmosphäre abgeschieden wird.

19. Verfahren nach Anspruch 18,
**dadurch gekennzeichnet, daß** bei Durchführung eines reaktiven Hochfrequenz-Zerstäubens eine Abscheideleistung bei Abscheidung der Titanoxidschicht (14) im Bereich von 200 bis 600 W liegt.

20. Verfahren nach einem der Ansprüche 18 oder 19,
**dadurch gekennzeichnet, daß** bei Durchführung eines reaktiven Hochfrequenz-Zerstäubens eine Abscheidetemperatur bei Abscheidung der Titanoxidschicht (14) im Bereich von Raumtemperatur bis 600°C liegt.

21. Verfahren nach einem der Ansprüche 11 bis 20, ferner umfassend nach dem Schritt a) das Abscheiden einer Siliziumoxinitrid-Schicht (18) auf der Vanadiumoxidschicht (16).

22. Verfahren nach Anspruch 21,
**dadurch gekennzeichnet, daß** die Siliziumoxinitrid-Schicht (18) durch ein Zerstäubungsverfahren, vorzugsweise Magnetron-Zerstäuben oder reaktives Hochfrequenz-Zerstäuben eines Silizium-Targets in einer ein Argon/Sauerstoff/Stickstoff-Gemisch enthaltenden Atmosphäre abgeschieden wird.

23. Verfahren nach Anspruch 22,
**dadurch gekennzeichnet, daß** bei Durchführung eines reaktiven Hochfrequenz-Zerstäubens eine Abscheideleistung bei Abscheidung der Siliziumoxinitrid-Schicht (18) im Bereich von 200 bis 300 W liegt.

24. Verfahren nach einem der Ansprüche 22 oder 23,
**dadurch gekennzeichnet, daß** bei Durchführung eines reaktiven Hochfrequenz-Zerstäubens eine Abscheidetemperatur bei Abscheidung der Siliziumoxinitrid-Schicht im Bereich von Raumtemperatur bis 200°C liegt.

25. Verfahren zur Herstellung einer thermochromen Beschichtung, insbesondere für Glas, umfassend:
a) das Abscheiden einer Titanoxidschicht (14) auf einem Substrat (12), vorzugsweise Glassubstrat und
b) das Abscheiden einer vorzugsweise mit Wolfram oder Fluor dotierten Vanadiumoxidschicht (16) auf der Titanoxidschicht (14),
optional in Verbindung mit einem oder mehreren der Merkmale der Ansprüche 12 bis 24.

## Claims

1. Thermochromic coating, in particular for glass, comprising a vanadium oxide layer (16) which also comprises tungsten and fluorine.

2. Coating according to claim 1, **characterised in that** the tungsten content is in the range of 0.01 to 3.0 atom-%, preferably of 1.0 to 2.6 atom-%.

3. Coating according to any one of claims 1 and 2, **characterised in that** the fluorine content is in the range of 0.01 to 2 atom-%, preferably of 0.5 to 1.5 atom-%.

4. Coating according to any one of claims 1 to 3, **characterised in that** an intermediate layer (14) for arrangement between a substrate (12) carrying the vanadium oxide layer (16) and the vanadium oxide layer (16), wherein the intermediate layer (14) comprises a titanium oxide layer.

5. Thermochromic coating, in particular for glass, comprising a vanadium oxide layer (16) which comprises tungsten, preferably in the range from 1.0 to 2.6 atom-%, most preferably in the range of 1.6 to 2.0 atom-%, and wherein the coating (10) also comprises an intermediate layer (14) of titanium oxide which is or can be arranged between the vanadium oxide layer (16) and a substrate (12) carrying the vanadium oxide layer (16).

6. Thermochromic coating, in particular for glass, comprising a vanadium oxide layer (16) which comprises fluorine, preferably in the range of 0.01 to 3 atom-%, most preferably in the range of 0.5 to 2.5 atom-%, and wherein the coating (10) also comprises an intermediate layer (14) of titanium oxide which is or can be arranged between the vanadium oxide layer (16) and a substrate (12) carrying the vanadium oxide layer (16).

7. Coating according to any one of claims 1 to 6, also comprising a silicon oxynitride covering layer (18) on the vanadium oxide layer (16).

8. Coating according to claim 7, **characterised in that** the covering layer (18) has a thickness in the range of 10 to 300 nm, preferably of 10 to 100 nm.

9. Coating according to any one of claims 1 to 8, **characterised in that** the vanadium oxide layer has a thickness in the range of 30 to 350 nm, preferably of 50 to 150 nm.

10. Coating according to any one of claims 4, 5 and 6, or any one of claims 7 to 9 if they are sub-claims of claims 4, 5 and 6, **characterised in that** the intermediate layer (14) has a thickness in the range of 10 to 100 nm, preferably of 30 to 70 nm.

11. Process for the production of a thermochromic coating (10), in particular for glass, comprising
a) deposition of a vanadium oxide layer (16) doped with tungsten and fluorine.

12. Process according to claim 11, **characterised in that** the deposition of the vanadium oxide layer (16) is carried out by a sputtering process, preferably high-frequency sputtering or magnetron sputtering.

13. Process according to claim 11 or 12, **characterised in that** the doped vanadium oxide layer is deposited by reactive high-frequency sputtering of a tungsten-containing vanadium target in an atmosphere comprising an oxygen/argon mixture and trifluoromethane.

14. Process according to claim 13, **characterised in that** the trifluoromethane partial pressure is in the range 0.5 to 5·10⁻³ Pa.

15. Process according to any one of claims 13 and 14, **characterised in that** the deposition power during deposition of the vanadium oxide layer is in the range of 200 to 600 W.

16. Process according to any one of claims 13 to 15, **characterised in that** the deposition temperature during deposition of the vanadium oxide layer is in the range 200 to 600°C, preferably about 300°C.

17. Process according to any one of claims 11 to 16, also comprising, before step a), the deposition of a titanium oxide layer (14) on the substrate (12).

18. Process according to claim 17, **characterised in that** the titanium oxide layer (14) is deposited by a sputtering or reactive high-frequency sputtering, of a titanium target in an atmosphere comprising an oxygen/argon mixture.

19. Process according to claim 18, **characterised in that** during performance of reactive high-frequency sputtering, the deposition power during deposition of the titanium oxide layer (14) is in the range of 200 to 600 W.

20. Process according to any one of claims 18 to 19, **characterised in that** during performance of reactive high-frequency sputtering, the deposition temperature during deposition of the titanium oxide layer (14) is in the range of ambient temperature to 600°C.

21. Process according to any one of claims 11 to 20, also comprising, after step a) deposition of a silicon oxynitride layer (18) on the vanadium oxide layer (16).

22. Process according to claim 21, **characterised in that** the silicon oxynitride layer (18) is deposited by a sputtering process, preferably magnetron sputtering or reactive high-frequency sputtering, of a silicon target in an atmosphere comprising an argon/oxygen/nitrogen mixture.

23. Process according to claim 22, **characterised in that** during performance of reactive high-frequency sputtering, the deposition power during deposition of the silicon oxynitride layer (18) is in the range of 200 to 300 W.

24. Process according to any one of claims 22 and 23, **characterised in that** during performance of reactive high-frequency sputtering, the deposition temperature during deposition of the silicon oxynitride layer is in the range of ambient temperature to 200°C.

25. Process for the production of a thermochromic coating, in particular for glass, comprising:
a) deposition of a titanium oxide layer (14) on a substrate (12), preferably a glass substrate, and
b) deposition of a vanadium oxide layer (16), preferably doped with tungsten or fluorine, on the titanium oxide layer (14),
optionally in combination with one or more of the features of claims 12 to 24.

## Revendications

1. Revêtement thermochrome, en particulier pour verre, comprenant une couche d'oxyde de vanadium (16) qui contient en outre du tungstène et du fluor.

2. Revêtement selon la revendication 1,
**caractérisé en ce que** la teneur en tungstène se situe entre 0,01 et 3,0% en poids atomique, de préférence entre 1,0 et 2,6% en poids atomique.

3. Revêtement selon l'une des revendications 1 ou 2,
**caractérisé en ce que** la teneur en fluor se situe entre 0,01 et 2 % en poids atomique, de préférence entre 0,5 et 1,5 % en poids atomique.

4. Revêtement selon l'une des revendications 1 à 3,
**caractérisé par** une couche intermédiaire (14) à disposer entre le substrat (12) portant la couche d'oxyde de vanadium (16) et la couche d'oxyde de vanadium (16), la couche intermédiaire (14) comprenant une couche d'oxyde de titane.

5. Revêtement thermochrome, en particulier pour verre, comprenant une couche d'oxyde de vanadium (16) qui contient du tungstène, de préférence à raison de 1,0 à 2,6 % en poids atomique, de préférence encore à raison de 1,6 à 2,0 % en poids atomique, et le revêtement (10) comprenant en outre une couche intermédiaire (14) en oxyde de titane disposée ou pouvant être disposée entre la couche d'oxyde de vanadium (16) et un substrat (12) portant la couche d'oxyde de vanadium (16).

6. Revêtement thermochrome, en particulier pour verre, comprenant une couche d'oxyde de vanadium (16) qui contient du fluor, de préférence à raison de 0,01 à 3 % en poids atomique, de préférence encore à raison de 0,5 à 2,5 % en poids atomique, et le revêtement (10) comprenant en outre une couche intermédiaire (14) en oxyde de titane disposée ou pouvant être disposée entre la couche d'oxyde de vanadium (16) et un substrat (12) portant la couche d'oxyde de vanadium (16).

7. Revêtement selon l'une des revendications 1 à 6, comprenant en outre une couche de couverture (18) en nitrure d'oxyde de silicium sur la couche d'oxyde de vanadium (16).

8. Revêtement selon la revendication 7,
**caractérisé en ce que** la couche de couverture (18) présente une épaisseur comprise entre 10 et 300 nm, de préférence entre 10 et 100 nm.

9. Revêtement selon l'une des revendications 1 à 8,
**caractérisé en ce que** la couche d'oxyde de vanadium présente une épaisseur comprise entre 30 et 350 nm, de préférence entre 50 et 150 nm.

10. Revêtement selon l'une des revendications 4, 5 ou 6, ou l'une des revendications 7 à 9, dans la mesure où elles se rattachent à la revendication 4, 5 ou 6,
**caractérisé en ce que** la couche intermédiaire (14) présente une épaisseur comprise entre 10 et 100 nm, de préférence entre 30 et 70 nm.

11. Procédé de réalisation d'un revêtement thermochrome (10), en particulier pour verre, comprenant
a) la séparation d'une couche d'oxyde de vanadium (16) dopée avec du tungstène et du fluor.

12. Procédé selon la revendication 11, **caractérisé en ce que** la séparation de la couche d'oxyde de vanadium (16) s'effectue par un procédé de pulvérisation, de préférence par pulvérisation à haute fréquence ou pulvérisation par magnétron.

13. Procédé selon la revendication 11 ou 12,
**caractérisé en ce que** la couche d'oxyde de vanadium dopée est séparée par pulvérisation réactive à haute fréquence d'une cible de vanadium dans une atmosphère contenant un mélange d'oxygène et d'argon et du trifluorométhane.

14. Procédé selon la revendication 13,
**caractérisé en ce que** la pression partielle du trifluorméthane se situe entre 0,5 et 5 . 10⁻³Pa.

15. Procédé selon l'une des revendications 13 ou 14,
**caractérisé en ce que** la puissance de séparation dans la séparation de la couche d'oxyde de vanadium se situe entre 200 et 600 W.

16. Procédé selon l'une des revendications 13 à 15,
**caractérisé en ce que** dans la séparation de la couche d'oxyde de vanadium, la température de séparation est comprise entre 200 et 600 °C, de préférence d'environ 300 °C.

17. Procédé selon l'une des revendications 11 à 16, comprenant en outre, avant l'étape a), la séparation d'une couche d'oxyde de titane (14) sur le substrat (12).

18. Procédé selon la revendication 17,
**caractérisé en ce que** la couche d'oxyde de titane (14) est séparée par un procédé de pulvérisation, de préférence pulvérisation par magnétron, ou pulvérisation réactive à haute fréquence d'une cible de titane dans une atmosphère contenant un mélange d'oxygène et d'argon.

19. Procédé selon la revendication 18,
**caractérisé en ce qu'**au cours de l'exécution d'une pulvérisation active à haute fréquence, on a, pour la séparation de la couche d'oxyde de titane (14), une puissance de séparation qui se situe entre 200 et 600 W.

20. Procédé selon l'une des revendications 18 ou 19,
**caractérisé en ce que** pendant l'exécution d'une pulvérisation réactive à haute fréquence, on a, pour la séparation de la couche d'oxyde de titane (14), une température de séparation qui se situe entre la température ambiante et 600 °C.

21. Procédé selon l'une des revendications 11 à 20, comprenant en outre, après l'étape a), la séparation d'une couche de nitrure d'oxyde de silicium (18) sur la couche d'oxyde de vanadium (16).

22. Procédé selon la revendication 21,
**caractérisé en ce que** la couche de nitrure d'oxyde de silicium (18) est séparée, par un procédé de pulvérisation, de préférence pulvérisation par magnétron ou pulvérisation réactive à haute fréquence d'une cible de silicium dans une atmosphère contenant un mélange d'argon, d'oxygène et d'azote.

23. Procédé selon la revendication 22,
**caractérisé en ce qu'**au cours de l'exécution d'une pulvérisation réactive à haute fréquence, on a, pour la séparation de la couche de nitrure d'oxyde de silicium (18), une puissance de séparation qui se situe entre 200 et 300 W.

24. Procédé selon l'une des revendications 22 ou 23,
**caractérisé en ce qu'**au cours de l'exécution d'une pulvérisation réactive à haute fréquence, on a, pour la séparation de la couche de nitrure d'oxyde de silicium, une température de séparation qui se situe entre la température ambiante et 200 °C.

25. Procédé de réalisation d'un revêtement thermochrome, en particulier pour verre, comprenant :
a) la séparation d'une couche d'oxyde de titane (14) sur un substrat (12), de préférence un substrat en verre, et
b) la séparation d'une couche d'oxyde de vanadium (16), de préférence dopée avec du tungstène ou du fluor, sur la couche d'oxyde de titane (14),
en option en combinaison avec une ou plusieurs des caractéristiques des revendications 12 à 24.
